Europäisches Patentamt

European Patent Office

Office européen des brevets

(19)

(11) Veröffentlichungsnummer: **0 199 007**
**A2**

(12) **EUROPÄISCHE PATENTANMELDUNG**

(21) Anmeldenummer: 86101956.0

(22) Anmeldetag: 15.02.86

(51) Int. Cl.⁴: **H 05 K 7/14**

(30) Priorität: 23.04.85 DE 3514617

(43) Veröffentlichungstag der Anmeldung:
29.10.86 Patentblatt 86/44

(84) Benannte Vertragsstaaten:
AT BE CH DE FR GB IT LI LU NL SE

(71) Anmelder: Bodenseewerk Gerätetechnik GmbH
Alte Nussdorfer Strasse 15 Postfach 1120
D-7770 Überlingen/Bodensee(DE)

(72) Erfinder: Steimel, Johannes
Zur Schiffslände 20
D-7750 Konstanz 13(DE)

(72) Erfinder: Kirchner, Manfred
Brunnenstrasse 28
D-7769 Hohenfels 1(DE)

(74) Vertreter: Weisse, Jürgen, Dipl.-Phys. et al,
Patentanwälte Dipl.-Phys. Jürgen Weisse Dipl.-Chem. Dr.
Rudolf Wolgast Bökenbusch 41 Postfach 11 03 86
D-5620 Velbert 11 Langenberg(DE)

(54) Trägerplattenanordnung für hohe Beschleunigungen.

(57) Eine Trägerplattenanordnung für hohe Beschleunigungen enthält eine Trägerplatte (10), die in der Richtung der zu erwartenden Beschleunigung gewölbt ausgebildet ist. Die Trägerplatte (10) ist axial und radial in einem Rahmen (12) abgestützt. Die Kontaktierung erfolgt über Kontaktstifte (32) und abgefederte Flachkontakte (36, 38).

## Trägerplattenanordnung für hohe Beschleunigungen

Die Erfindung betrifft eine Trägerplattenanordnung mit einer Trägerplatte zur Aufnahme elektronischer Bauelemente für Geräte, die hohen Beschleunigungen in einer vorgegebenen Richtung unterworfen sind.

Es ist üblich, elektronische Bauteile oder Baugruppen auf Trägerplatten zu montieren, welche gleichzeitig die Leiterbahnen zum Zusammenschalten der Bauteile oder Baugruppen enthalten. Solche Trägerplatten sind üblicherweise plan ausgebildet. Es gibt Anwendungen, bei denen das Gerät, zu dem die Trägerplatte gehört, extrem hohen Beschleunigungen in einer vorgegebenen Richtung ausgesetzt sind. Beispiele hierfür sind Flugkörper oder endphasengelenkte Munition und Geschosse. Um bei solchen Anwendungen eine ausreichende Festigkeit und Stabilität der Trägerplattenanordnung zu erzielen, ist es bekannt, die gesamten Elektronikbaugruppen mit Gießharz zu vergießen. Das hat aber den Nachteil, daß sich das Gewicht in unerwünschter Weise erhöht. Es ist nach dem Vergießen auch nicht mehr möglich, an der Schaltung irgendetwas zu ändern oder nachzubessern, z.B. ein fehlerhaftes Bauelement zu ersetzen.

Der Erfindung liegt die Aufgabe zugrunde; eine einfache und leichte Trägerplattenanordnung · für hohe Beschleunigungen zu schaffen.

Erfindungsgemäß wird diese Aufgabe dadurch gelöst, daß die Trägerplatte in der Richtung der Beschleunigung gewölbt ausgebildet ist.

Es hat sich gezeigt, daß eine so gewölbte Trägerplatte auch ohne Vergießen extrem hohen Beschleunigungen und Trägheitskräften zu widerstehen vermag, wie sie beispielsweise beim Abschuß eines Geschosses oder eines Flugkörpers auftreten.

Ausgestaltungen der Erfindung sind Gegenstand der Unteransprüche.

Ein Ausführungsbeispiel der Erfindung ist nachstehend unter Bezugnahme auf die zugehörige Zeichnung näher erläutert, die einen Schnitt durch eine Trägerplattenanordnung zeigt.

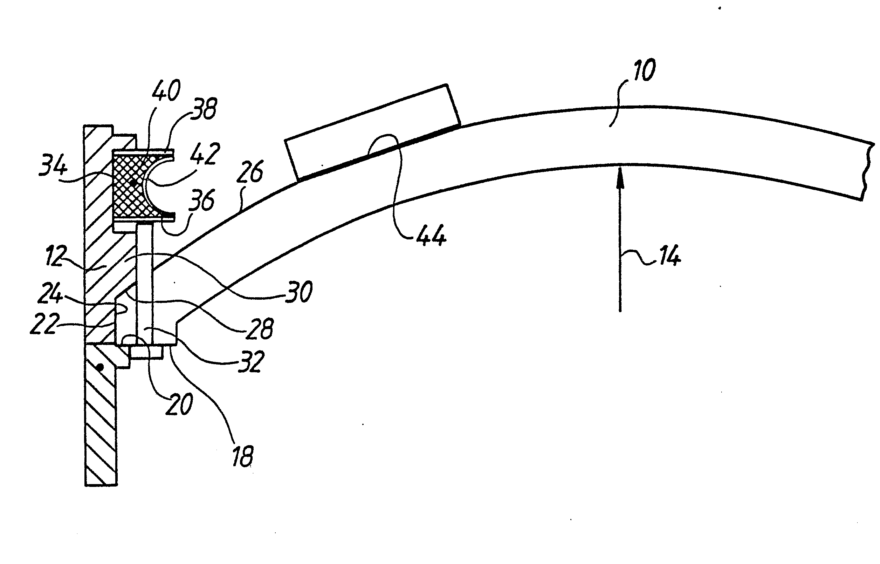

Eine Trägerplatte 10 ist in einem Rahmen 12 gehaltert. Das Gerät mit der Trägerplatte 10 ist einer starken Beschleunigung in Richtung des Pfeiles 14 unterworfen, also nach oben in der Figur. Die dadurch hervorgerufenen Trägheitskräfte wirken dann nach unten in der Figur. Um diese Trägheitskräfte aufzunehmen, ist die Trägerplatte 10 in Richtung der zu erwartenden Beschleunigung gewölbt. Die Trägerplatte kann dabei einen Kugelabschnitt bilden. Sie kann aber auch beispielsweise die Form eines Paraboloids besitzen.

Die Trägerplatte 10 ist axial und radial in dem Rahmen 12 abgestützt. Eine Planfläche 18 am Umfang der Trägerplatte auf deren konkaver Seite liegt auf einer Schulter 20 des Rahmens 12 auf. Die Mantelfläche 22 der Trägerplatte 10 liegt radial an einer sich an die Schulter 20 anschließenden, zylindrischen Innenfläche 24 des Rahmens 12 an. Schließlich ist der Rand der konvexen Fläche 26 der Trägerplatte 10 von einer entsprechend konkaven Fläche 28 einer Leiste 30 auf der Innenseite des Rahmens 12 gehalten. Die Trägerplätte 10 ist auf der konvexen Fläche 26 mit elektronischen Bauelementen bestückt. Die Trägheitskräfte werden von der gewölbten Trägerplatte 10 aufgenommen und über die Flächen 18 und 22 auf den Rahmen 12 abgeleitet.

Am Umfang der Trägerplatte 10 sind Kontaktstifte 32 angeordnet, über welche die elektrischen Anschlüsse der Trägerplatte 10 hergestellt werden. In einer Umfangsausnehmung 34 auf der Innenseite des Rahmens 12 sind Paare von Flachkontakten 36 und 38 gehaltert, die durch einen dazwischenliegenden, gummielastischen Ring 40 abgefedert sind. Die Flachkontakte 36 und 38 sind durch ein federndes Zwischenstück 42 leitend miteinander verbunden. Der Flachkontakt 36 liegt federnd an dem Kontaktstift 32 an.

Die Trägerplatte 10 kann aus glasfaserverstärktem Kunststoff bestehen. Die Trägerplatte 10 kann aber auch beispielsweise aus einem keramischen Werkstoff hergestellt sein.

Die gewölbte Trägerplatte 10 kann in entsprechenden Formen gegossen werden. Dabei kann die Formgebung der konvexen Fläche 26 so sein, daß ein gleichmäßiger Flächenkontakt zwischen den Bauelementen und der Trägerplatte 10 gewährleistet ist. Bei Verwendung großer Elektronikbauteile müssen hierzu entsprechend große, an die Form dieser Elektronikbauteile angepaßte, z.B. plane, Flächenteile der Fläche 26 vorgesehen werden, wie in der Figur·bei 44 angedeutet ist.

Patentansprüche

1. Trägerplattenanordnung mit einer Trägerplatte zur Aufnahme elektronischer Bauelemente für Geräte, die hohen Beschleunigungen in einer vorgegebenen Richtung unterworfen sind, dadurch gekennzeichnet, daß die Trägerplatte (10) in der Richtung der Beschleunigung (14) gewölbt ausgebildet ist.

2. Trägerplattenanordnung nach Anspruch 1, dadurch gekennzeichnet, daß die Trägerplatte (10) axial und radial in einem Rahmen (12) abgestützt ist.

3. Trägerplattenanordnung nach Anspruch 1, dadurch gekennzeichnet, daß

   (a) am Umfang der Trägerplatte (10) Kontaktstifte (32) angeordnet sind, welche die Trägerplatte (10) durchsetzen und

   (b) in einer Umfangsausnehmung (34) auf der Innenseite des Rahmens (12) Paare von leitend miteinander verbundenen Flachkontakten (36,38) gehaltert sind, die durch einen dazwischenliegenden, gummielastischen Ring (40) abgefedert sind und federnd an den Kontaktstiften (32) anliegen.

0199007